(19) Europäisches Patentamt
European Patent Office
Office européen des brevets

(11) EP 2 144 118 A1

(12) EUROPEAN PATENT APPLICATION

(43) Date of publication:
13.01.2010 Bulletin 2010/02

(51) Int Cl.:
G03F 7/20 (2006.01)

(21) Application number: 09008010.2

(22) Date of filing: 18.06.2009

(84) Designated Contracting States:
AT BE BG CH CY CZ DE DK EE ES FI FR GB GR
HR HU IE IS IT LI LT LU LV MC MK MT NL NO PL
PT RO SE SI SK TR

(30) Priority: 07.07.2008 JP 2008177404

(71) Applicant: Canon Kabushiki Kaisha
Tokyo (JP)

(72) Inventors:
• Kawashima, Haruna
Tokyo (JP)
• Saito, Nobuyuki
Tokyo (JP)

(74) Representative: Weser, Thilo et al
Weser & Kollegen
Patentanwälte
Radeckestrasse 43
81245 München (DE)

(54) **Exposure apparatus and method of manufacturing device**

(57) An exposure apparatus comprises an optical system (21) configured to illuminate a reticle, including an imaging optical system (212) having an optical element (201), a reflecting surface which reflects light toward the optical element, and a processor (P) which extracts information from a first signal based on first light which is incident on the imaging optical system and reflected by the reflecting surface and a surface of the optical element, and information from a second signal based on second light which is incident on the imaging optical system , and which obtains information indicating a surface condition of the optical element using the information extracted from the first and second signals.

**F I G. 1A**

EP 2 144 118 A1

**Description**

BACKGROUND OF THE INVENTION

Field of the Invention

The present invention relates to an exposure apparatus and a method of manufacturing a device.

Description of the Related Art

In a photolithography process for manufacturing a semiconductor element, a liquid crystal display element, or the like, a circuit pattern with a fine line width formed on a reticle or the like is projected/exposed on a photosensitive substrate such as a wafer coated with a resist layer using a projection exposure apparatus having a high resolving power.

In this projection/exposure step, a volatile substance produced from a photosensitive resin used for a resist layer applied to the wafer adheres to the surface of an optical member of a projection optical system, thus contaminating the optical member surface. For this reason, the operator of a projection exposure apparatus needs to perform wiping operation, that is, cleaning operation, on the optical member surface of the projection optical system. With regard to the execution timing of the above cleaning operation, the operator performs it when visually recognizing the contaminated state or periodically performs it at a predetermined constant periodic timing.

Recently, with increasing miniaturization of semiconductor integrated circuits, the line width uniformity of a transferred pattern is used in a semiconductor exposure apparatus. As a factor that degrades the line width uniformity, the influence of flare occurring in a projection optical system and an illumination optical system has become no longer negligible. The flare occurring in the projection optical system and the illumination optical system makes the illuminance distribution within the exposure screen nonuniform to cause nonuniformity in the line width of an optical image within the screen. When a portion outside the exposure screen is irradiated with flare, nonuniformity occurs in the line widths of optical images in adjacent shots. Flare occurs in the projection optical system and the illumination optical system when the reflectance of the surface of an optical element increases due to contamination or the like on the optical element surface.

Conventionally, flare in the projection optical system and the illumination optical system is estimated from an exposure result on a wafer coated with a resist. For example, the amount of flare occurring in the entire projection optical system and illumination optical system is predicted from a change in the line width of a pattern image exposed by the semiconductor exposure apparatus or a change in the amount of resist film residue outside an exposure region which remains after exposure is performed in a plurality of shots while changing the exposure amount.

Japanese Patent Laid-Open No. 11-283903 proposes a measurement unit which automatically measures contamination on the surface of an optical element in a projection optical system. Japanese Patent Laid-Open No. 11-283903 discloses a measurement unit which automatically measures the reflectance of the surface of an optical element which is closest to a photosensitive substrate, and a photo-cleaning unit which automatically removes contamination on the surface of the optical element which is closest to the photosensitive substrate.

According to the technique described in Japanese Patent Laid-Open No. 11-283903, a measuring light beam is made obliquely incident on the surface of the optical element on the photosensitive substrate side from outside the projection optical system and the illumination optical system without passing through these systems, and the amount of reflected light of the measuring light beam is measured. Therefore, it is difficult to measure the reflectance on the surface of an inner optical element of the illumination optical system. As described above, according to the prior art, it is difficult to measure an increase in flare in each of the optical elements constituting the illumination optical system.

According to the technique described in Japanese Patent Laid-Open No. 11-283903, a light source is additionally provided between the projection optical system and the photosensitive substrate to implement the measurement unit which automatically performs measurement. This complicates the arrangement of the exposure apparatus.

SUMMARY OF THE INVENTION

According to an aspect of the present invention, there is provided an exposure apparatus, which project a reticle pattern onto a substrate and exposes the substrate, as specified in claims 1 to 11.

Further features of the present invention will become apparent from the following description of exemplary embodiments with reference to the attached drawings.

BRIEF DESCRIPTION OF THE DRAWINGS

Fig. 1A is a view for explaining an exposure apparatus according to the first embodiment;

Fig. 1B is a view for explaining the exposure apparatus according to the first embodiment;

Fig. 1C is a flowchart for measurement in the first embodiment;

Fig. 2A is a view for explaining an exposure apparatus according to the second embodiment;

Fig. 2B is a view for explaining the exposure apparatus according to the second embodiment;

Fig. 3A is a view for explaining an exposure apparatus according to the third embodiment;

Fig. 3B is a view for explaining the exposure apparatus according to the third embodiment; and

Fig. 4 is a flowchart for measurement in the fourth embodiment.

DESCRIPTION OF THE EMBODIMENTS

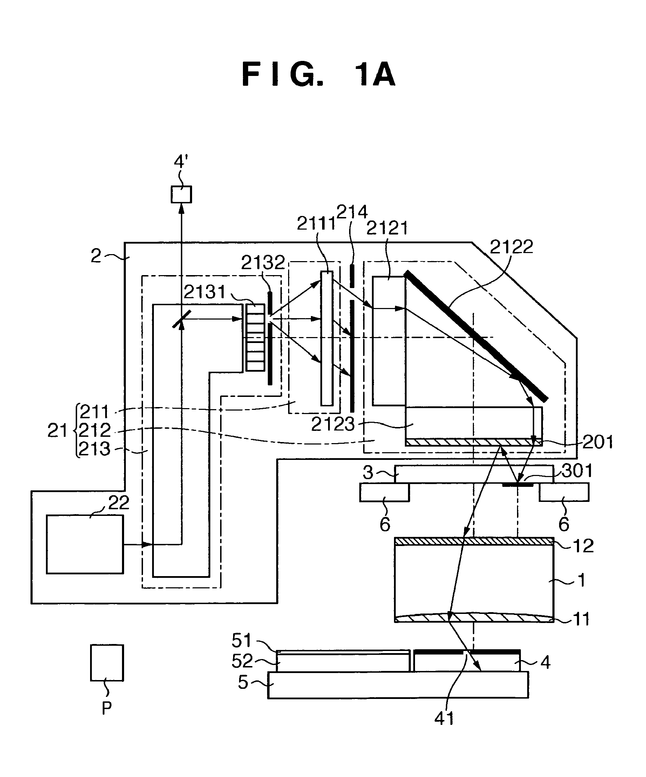

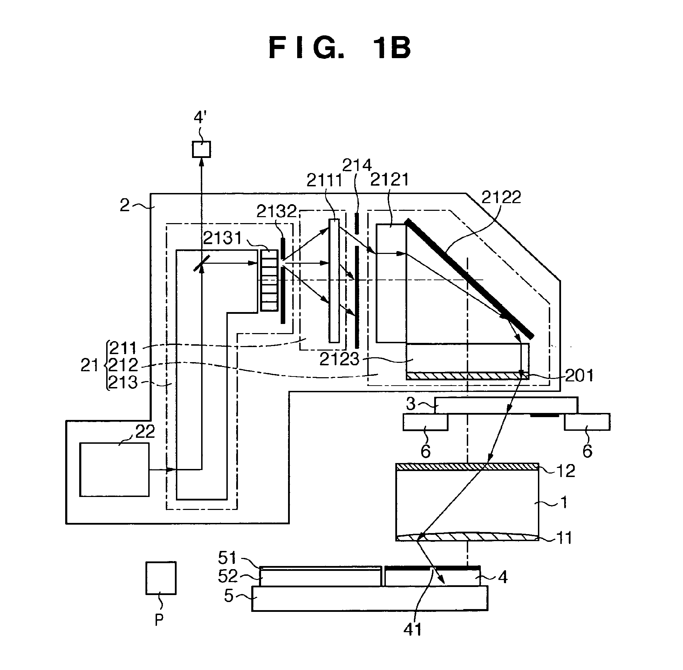

A first embodiment of an exposure apparatus according to the present invention will be described with reference to Figs. 1A and 1B. An illumination system 2 includes a light source 22 such as a laser and an illumination optical system 21 which receives light from the light source 22.

Light from the light source 22 illuminates a reticle placed on a reticle stage 6 via the illumination optical system 21 with an illumination mode (effective light source shape), a polarization state, and an illuminance distribution. The illumination optical system 21 further includes an optical system 213 which forms an effective light source, a Koehler illumination optical system 211, and an imaging illumination optical system 212. A variable aperture masking blade 214 is placed at or near a position which is optically conjugate with the reticle through the imaging illumination optical system 212. The masking blade 214 can limit the illumination range on the reticle within a region. An exposure amount sensor 4' to control the exposure amount of the illumination system 2 is placed between the light source 22 and the imaging illumination optical system 212. The exposure amount sensor 4' forms a second sensor which detects the amount of light incident on the imaging illumination optical system 212.

A pattern is formed on the lower surface of the reticle. Diffracted light from this pattern is projected, via a projection optical system 1, on a resist-coated substrate 51 placed on a substrate stage 5 which supports a substrate, thus transferring the pattern onto the substrate 51. In general, at least one of the object plane side and image plane side of the projection optical system 1 used for the exposure apparatus serves as a telecentric optical system. Making the image plane side telecentric, in particular, can theoretically eliminate a change in imaging magnification when the focus is adjusted by changing the level of the substrate. If the object plane (reticle) side of the projection optical system 1 is made telecentric, the image plane (reticle) side of the illumination optical system 21 is also telecentric. A substrate such as a wafer or glass plate will be referred to as "a wafer" hereinafter. Optical elements 11 and 12 are respectively positioned at the wafer side and the reticle side of the projection optical system 1.

Inner optical elements constituting the projection optical system 1 and the illumination system 2 are purged with a gas such as clean dry air or inert gas that does not contain any contaminants, so the surfaces of the optical elements are not easily contaminated. The outermost surfaces of the optical system which form the object plane (reticle) side and image plane side of the projection optical system 1 are respectively in contact with the space where driving mechanisms such as a reticle stage 6 and the substrate stage 5 are present. Likewise, the outermost surface of the optical system which forms the image plane (reticle) side of the illumination optical system 21 is also in contact with the space where a driving mechanism such as the reticle stage 6 is present.

The space where the reticle stage 6 and the substrate stage 5 are present cannot be completely free from contaminants in the atmosphere due to the presence of the driving mechanisms. For this reason, the surfaces of the optical elements of the projection optical system 1 and illumination system 2 which are in contact with this space are easily affected by contamination. Therefore, the outermost surfaces of the optical system which form the object plane side and image plane side of the projection optical system 1 are configured to be replaced as needed. Likewise, the outermost surface of the optical system which forms the image plane (reticle) side of the illumination optical system 21 is configured to be replaced as needed. Replaceably providing optical elements most susceptible to contamination in this manner can keep the optical performance of the illumination optical system 21 constant for a long period of time.

A scanning type semiconductor exposure apparatus performs pattern transfer while synchronously scanning the reticle stage 6 and the substrate 51. A reticle transport system and a wafer transport system (neither is shown) load and unload a reticle and the wafer 51 in and from the exposure apparatus, respectively. The reticle and the wafer 51 loaded by the corresponding transport systems are chucked and fixed on the reticle stage 6 and a wafer chuck 52, respectively.

The reticle stage 6 can be driven in the scanning direction (a direction perpendicular to the drawing surface of each of Figs. 1A and 1B), and the substrate stage 5 can be driven in the scanning direction and a direction perpendicular to the scanning direction. An autofocus mechanism (not shown) can drive the substrate stage 5 to allow it to perform leveling driving in the horizontal plane and to control it in the optical axis direction (the vertical direction in Figs. 1A and 1B) of the projection optical system 1 in order to bring the surface of the wafer 51 into focus on the best imaging plane of the projection optical system 1. A wafer side light amount sensor 4 is formed on the substrate stage 5. The wafer side light amount sensor 4 forms a first sensor which detects the light which is incident on the imaging illumination optical system 212 and emitted by the imaging illumination optical system 212. A processor P controls the illumination system 2, the reticle stage 6, and the substrate stage 5.

Measurement of a surface reflectance as information representing the surface condition of a reticle side optical element 201 of the illumination optical system 21 will be described next. In each of the states shown in Figs. 1A and 1B, the reflectance of the reticle side optical element 201 of the illumination optical system 21 is calculated based on the light amount measurement value of the exposure amount sensor 4' formed in the illumination system 2 and the light amount measurement value of the wafer side light amount sensor 4 formed on the substrate stage 5.

Measurement of the reflectance of the surface of an optical element in the state in Fig. 1A will be described. The light emitted by the light source 22 in the illumination system 2 enters the illumination optical system 21. The illumination optical system 21 includes the optical system 213 which forms an effective light source, the Koehler illumination optical system 211, the masking blade 214, and the imaging illumination optical system 212.

A monopole effective light source is formed by the optical system 213 forming an effective light source. The monopole obliquely incident light beam formed via the Koehler illumination optical system 211 illuminates a reflecting surface 301 formed on a test reticle 3 via the imaging illumination optical system 212. The reflecting surface 301 is formed on the surface of the test reticle 3 which is located on the projection optical system side. This embodiment exemplifies a case in which the reflecting surface 301 is placed on or near the image plane of the illumination optical system 21. Providing the reflecting surface 301 at a position where no contamination occurs in this manner can minimize changes in the reflectance of the reflecting surface 301.

A monopole obliquely incident light beam is formed by providing an effective light source stop 2132 on the exit surface of an integrator such as a fly-eye lens 2131 in the optical system 213 forming an effective light source and extracting a light beam from part of the effective light source. At this time, the exit surface of the integrator such as the fly-eye lens 2131 is optically a pupil plane relative to the reticle plane. By using a switching mechanism for a plurality of stops in a turret form or a variable aperture driving stop mechanism as the effective light source stop 2132, part of an effective light source can be extracted.

The surface reflectance of the optical element 201 which is a measurement target is as low as about 0.1 to 0.2%. In order to measure the surface reflectance of the optical element 201, therefore, it can be done to form an effective light source with a σ value of about 0.1 at the position of the effective light source stop 2132 by using a diffraction optical element such as a computer generated hologram (CGH). This makes it possible to form an obliquely incident light beam with a light amount exhibiting an illuminance several ten times higher than that obtained when monopole illumination light is extracted from a general uniform illumination with a σ value of about 0.8. Since this makes it possible to detect a light amount with a high S/N ratio, a reflectance can be measured with high accuracy.

The light beam exiting from the effective light source stop 2132 Koehler-illuminates a given surface of the masking blade 214, which is a variable aperture stop, via the Koehler illumination optical system 211 formed by a collimator 2111 constituted by a plurality of optical elements. At this time, a given surface of the masking blade 214 is illuminated with an obliquely incident light beam by placing the effective light source stop 2132 at a position eccentric to the optical axis of the collimator 2111.

The masking blade 214 transmits only a light beam in part of the region Koehler-irradiated by the collimator 2111. The light beam passing through the masking blade 214 is deflected by a bending mirror 2122 via a front group 2121 of the imaging illumination optical system, passes through a rear group 2123 of the imaging illumination optical system, and is focused on the reflecting surface 301 of the test reticle 3.

The front group 2121 of the imaging illumination optical system, the bending mirror 2122, and the rear group 2123 of the imaging illumination optical system constitute the imaging illumination optical system 212. The imaging illumination optical system 212 forms an aperture image of the masking blade 214 on the reflecting surface 301 of the test reticle 3. For the sake of simplicity, the following description will be made under the assumption that the imaging magnification of the imaging illumination optical system 212 is 1:1 magnification.

The light beam focused on and reflected by the reflecting surface 301 of the test reticle 3 is reflected by the surface of the reticle side optical element 201 located on the outermost side of the rear group 2123 of the imaging illumination optical system, and passes through the test reticle 3. This light beam then enters the projection optical system 1. The light beam which has entered the projection optical system 1 passes through a light-receiving aperture 41 of the wafer side light amount sensor 4 mounted on the substrate stage 5, and is received by the wafer side light amount sensor 4 to be photoelectrically converted. The wafer side light amount sensor 4 forms a first sensor which detects the light which is incident on the imaging illumination optical system 212 and emitted by the imaging illumination optical system 212.

At this time, the position of the substrate stage 5 at which an obliquely incident light beam enters a light-receiving aperture 41 is calculated in advance, and the substrate stage 5 is driven to the position in advance. The position at which the obliquely incident light beam enters the light-receiving aperture 41 can be obtained by calculating a so-called light beam trace from the following five pieces of information:

- the data of the imaging illumination optical system 212;
- the position at which a light beam enters the test reticle 3;
- the incident angle at which a light beam enters the test reticle 3;
- the designation of the surface of an optical element, of which reflectance is to be measured, in the imaging illumination optical system 212; and
- the optical data of the projection optical system 1.

A person skilled in the art can easily perform this calculation by automatic calculation using a computer in the projection exposure apparatus.

The reticle side optical element 201 placed on the outermost side of the rear group 2123 of the imaging illumination optical system is often a transmissive element such as an easily replaceable plane-parallel plate.

Measurement of the reflectance of the optical element in the state in Fig. 1A will be described quantitatively. In the state in Fig. 1A, assume that the exposure amount sensor 4' provided in the illumination system 2 and the wafer side light amount sensor 4 placed on the substrate stage 5 simultaneously perform light amount measurement. At this time, note that the light amount measured by the exposure amount sensor 4' provided in the illumination system is represented by IN(1a) and the light amount measured by the wafer side light amount sensor 4 is represented by OUT(1a).

The illuminance of the light beam which illuminates the masking blade 214 is the value of K·IN(1a) obtained by multiplying the light amount IN(1a) measured by the exposure amount sensor 4' provided in the illumination system by a measurement efficiency K determined by the position of the exposure amount sensor 4' in the illumination system.

Letting IT be the transmittance of the imaging illumination optical system 212, the illuminance of a light beam illuminating the test reticle 3 is the value given by K·IT·IN(1a).

Letting GT be the transmittance of the glass surface of the test reticle 3, CDR be the reflectance of the reflecting surface 301 of the test reticle 3, and ILLR be the reflectance of the reticle side optical element 201, the illuminance of the light beam reflected by the reflecting surface 301 of the test reticle 3 and the reticle side optical element 201 immediately after passing through the test reticle 3 is given by

$$K \cdot IT \cdot IN(1a) \cdot (GT^4) \cdot CDR \cdot ILLR$$

The imaging magnification of the projection optical system 1 mounted in the exposure apparatus is generally a reduction magnification of 1/4 or 1/5 or the like. For the sake of simplicity, the following description will be made under the assumption that the projection optical system 1 has an imaging magnification of 1x. A discussion on the case of a reduction magnification of $1/\beta$ is apparent, and hence will be omitted.

When the light amount distribution of the light beam immediately after passing through a transmissive aperture formed by the masking blade 214 exhibits uniform light intensity, the light amount distribution of the light beam focused (imaged) on the reflecting surface 301 of the test reticle 3 also exhibits uniform light intensity.

However, in a state in which the light beam reflected by the reflecting surface 301 of the test reticle 3 and the surface of the reticle side optical element 201 has reached the wafer side light amount sensor 4 via the projection optical system 1, the light amount distribution of the light beam which irradiates the light-receiving aperture 41 does not exhibit uniform light intensity. This is because the image of the transmissive aperture formed by the masking blade 214 is defocused on the wafer side light amount sensor 4.

If the light intensity distribution at the imaging position is uniform, the light intensity distribution in the defocused state appears such that the light amount distribution widens due to blurring of an image accompanying an increase in defocus amount, and the light intensity decreases from the peripheral portion of the image. The decrease in light intensity at the peripheral portion of the image due to the blurring of the image is determined by the defocus amount and the light beam diffusion (NA) of the illumination light beam, and can be easily obtained by performing light beam trace in the imaging illumination optical system 212 and the projection optical system 1 in consideration of the light beam diffusion (NA) of the illumination light beam. Therefore, by setting the diameter of the transmissive aperture formed by the masking blade 214 to be larger by the defocus amount of this image in advance, the light amount distribution of the light beam which irradiates the light-receiving aperture 41 can have a uniform distribution in the aperture portion of the light-receiving aperture 41.

When the transmissive aperture formed by the masking blade 214 is set to have a large diameter in this manner, the illuminance of the light beam which enters the light-receiving aperture 41 on the wafer side light amount sensor 4 is expressed by

$$K \cdot IT \cdot IN(1a) \cdot (GT^4) \cdot CDR \cdot ILLR \cdot PT$$

where PT is the transmittance of the projection optical system 1.

Letting WT be the transmittance of the light-receiving aperture 41, the illuminance of the light beam immediately after passing through the light-receiving aperture 41 is given by

$$K \cdot IT \cdot IN(1a) \cdot (GT^4) \cdot CDR \cdot ILLR \cdot PT \cdot WT$$

Assume that the wafer side light amount sensor 4 photoelectrically converts a light beam passing through the light-receiving aperture 41. Letting WK be the photoelectric conversion efficiency of the wafer side light amount sensor 4, the light amount OUT(1a) measured by the wafer side light amount sensor 4 is expressed as

$$OUT(1a) = K \cdot IT \cdot IN(1a) \cdot (GT^4) \cdot CDR \cdot ILLR \cdot PT \cdot WT \cdot WK$$

The surface reflectance ILLR of the reticle side optical element 201 is obtained by solving

$$ILLR = \{OUT(1a)/IN(1a)\}/\{K \cdot (GT^4) \cdot IT \cdot PT \cdot CDR \cdot WT \cdot WK\}$$

The following constant terms are obtained to the apparatus in advance:

$$\{K \cdot GT^4\} \cdot IT \cdot PT \cdot CDR \cdot WT \cdot WK\}$$

Of these constant terms, the characteristics of the following five terms can be measured in the respective unit states before the units are built in the exposure apparatus:

- the measurement efficiency K of the exposure amount sensor 4' in the illumination system 2;
- the transmittance PT of the projection optical system 1;
- the transmittance IT of the imaging illumination optical system 212;
- the transmittance WT of the light-receiving aperture 41 of the wafer side light amount sensor 4; and
- the photoelectric conversion efficiency WK of the wafer side light amount sensor 4.

These constant terms indicate different values depending on the incident angle of a light beam. Therefore, the optical characteristics are measured in the respective units at different incident angles. A lot of labor is consumed to implement such a measurement environment. Assume that these characteristics are obtained in advance. Even in this case, if the characteristics have changed with time as the units are built in the apparatus and used for a long period of time, the change with time in constant terms directly affects the reliability of the measurement value of the surface reflectance ILLR of the reticle side optical element 201.

It is therefore not advisable to obtain ILLR from the equation obtained in the state in Fig. 1A and including seven types of constant terms unique to the apparatus. ILLR should be obtained from an equation including as fewer constant terms unique to the apparatus as possible. It is possible to reduce such constant terms by performing measurement in Fig. 1B as well.

Measurement in the state in Fig. 1B will be described next. A description similar to that made with reference to Fig. 1A will be omitted. The difference from the state in Fig. 1A is that a light beam passing through the transmissive aperture formed by the masking blade 214 is directly focused on the light-receiving aperture 41 of the wafer side light amount sensor 4 by the projection optical system 1, and passes through the light-receiving aperture 41. At this time, the position of a light beam passing through the projection optical system 1 differs between the states in Figs. 1A and 1B. However, since PT (the state in Fig. 1A) ≈ PT (the state in Fig. 1B), the following description will be made under the assumption that the transmittances PT in both the states are equal to each other.

Measurement in Fig. 1B will be described quantitatively. Letting IN(1b) be the light amount measured by the exposure amount sensor 4' provided in the illumination system 2, the light amount OUT(1b) measured by the wafer side light amount sensor 4 is expressed as

$$OUT(1b) = K \cdot IT \cdot IN(1b) \cdot (GT^2) \cdot PT \cdot WT \cdot WK$$

When the surface reflectance ILLR of the reticle side optical element 201 is calculated using two equations (1) and (2) given below which are obtained in the states in Figs. 1A and 1B, the surface reflectance ILLR is expressed by equation (3):

$$OUT(1a) = K \cdot IT \cdot IN(1a) \cdot (GT^4) \cdot CDR \cdot ILLR \cdot PT \cdot WT \cdot WK$$

$$\ldots(1)$$

$$OUT(1b) = K \cdot IT \cdot IN(1b) \cdot (GT^2) \cdot PT \cdot WT \cdot WK \qquad \ldots(2)$$

$$ILLR = \{OUT(1a)/IN(1a)/OUT(1b)/IN(1b)\}$$
$$\cdot\{1/(GT^2 \cdot CDR)\} \qquad \ldots(3)$$

It is possible to obtain the surface reflectance ILLR of the reticle side optical element 201 by using only the four terms described below:

- the light amounts IN(1a) and IN(1b) measured by the exposure amount sensor 4' provided in the illumination system;
- the light amounts OUT(1a) and OUT(1b) measured by the wafer side light amount sensor 4;
- the reflectance CDR of the reflecting surface 301 of the test reticle 3; and
- the transmittance GT of the glass surface of the test reticle 3.

The above technique is very simple because the characteristics unique to the apparatus which should be stored in the exposure apparatus in advance include only the transmittance GT of the glass surface of the test reticle 3 and the reflectance CDR of the reflecting surface 301 of the test reticle 3. That is, it suffices to only actually measure in advance the relationship between the transmittance GT of the glass surface and the reflectance CDR of the reflecting surface 301 of the test reticle 3 and store it in the exposure apparatus in advance.

At this time, it suffices to obtain the relationship among the glass surface transmittance GT, the reflectance CDR of the reflecting surface 301 of the test reticle 3, and the incident angle of measuring light by computation in the exposure apparatus using the optical property value of the glass material of the test reticle 3 and that of the upper surface of the test reticle.

As described above, in this embodiment, that surface of the reflecting layer formed on the lower surface of the test reticle 3 which is located on the illumination optical system 21 side is formed into the reflecting surface 301. Even if, therefore, the test reticle 3 is erroneously contaminated, it does not influence the reflectance CDR of the reflecting surface 301 of the test reticle 3. Since the transmittance GT of the glass surface can be recovered easily by cleaning the test reticle 3 with a cleaning unit, a change with time in constant terms which affects the reliability of the measurement value of ILLR does not occur easily.

As the exposure amount sensor 4' to measure the light amounts IN(1a) and IN(1b), an exposure amount control sensor generally positioned in the illumination system 2 can be used. Likewise, as the wafer side light amount sensor 4 to measure the light amounts OUT(1a) and OUT(1b), an exposure amount control sensor generally positioned on the substrate stage can be used.

As described above, a simple arrangement using only the test reticle 3 provided with the reflecting surface 301 for a generally used exposure apparatus can measure the surface reflectance of the optical element 201 based on the detection results obtained by the wafer side light amount sensor 4 and the exposure amount sensor 4'.

The light which is incident on the imaging illumination optical system 212 and reflected by the reflecting surface 301 and the surface of the optical element 201 in the state in Fig. 1A forms the first light. The light which is incident on the imaging illumination optical system 212 and is not reflected by the reflecting surface 301 and the surface of the optical element 201 in the state in Fig. 1B forms the second light.

The above description is made under the assumption that the following two values are equal to each other in the states in Figs. 1A and 1B:

- the transmittance WT of the light-receiving aperture 41 of the wafer side light amount sensor 4; and
- the photoelectric conversion efficiency WK of the wafer side light amount sensor 4.

Strictly speaking, however, these values are equivalent only when the object (reticle) plane side of the projection optical system 1 and the image (reticle) plane side of the imaging illumination optical system 212 are nearly telecentric, and the outermost optical element 201 on the image (reticle) plane side, which is a reflectance measurement target, is a flat surface. Only under these conditions, it is possible to measure the surface reflectance of the reticle side optical element 201 in the imaging illumination optical system 212 without being influenced by the angular characteristics (the sensor output changes depending on the incident angle of a light beam on the sensor) of the sensitivity of the light amount sensor.

Even if these conditions are not satisfied, there is no issue when monitoring (repeating measurement every specific period of time) a change with time in the surface reflectance of the reticle side optical element 201 in the imaging illumination optical system 212.

In this case, approximation is made such that both the following two values are equal to each other in the states in Figs. 1A and 1B:

- the transmittance WT of the light-receiving aperture 41 of the wafer side light amount sensor 4; and
- the photoelectric conversion efficiency WK of the wafer side light amount sensor 4.

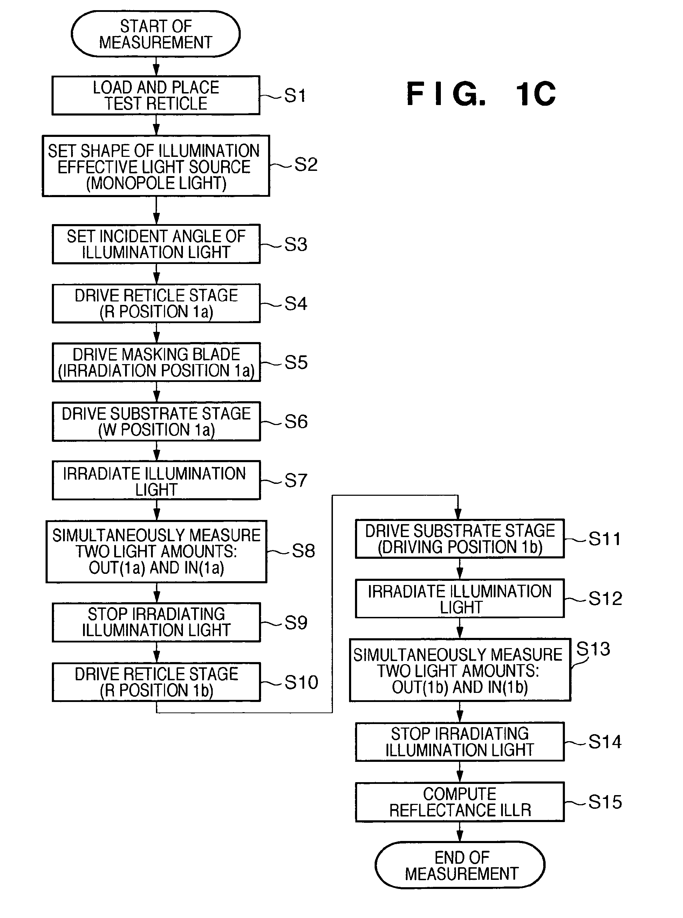

Fig. 1C shows a flowchart for reflectance measurement in the first embodiment. In step S1, the reticle transport system loads the test reticle 3 and places it on the reticle stage 6. Assume that the inner surface of the lower surface of the test reticle 3 has a plurality of reflecting surfaces 301 corresponding to the plurality of image heights in the imaging illumination optical system 212. In step S2, the processor P sets the shape of an illumination effective light source. The processor P drives a mechanism of switching the effective light source shape in the illumination system 2 to form monopole illumination light. In step S3, the processor P drives a mechanism of changing the effective light source in the illumination system 2 to set the incident angle (NA) of the illumination light to a predetermined value.

In step S4, the processor P drives the reticle stage 6 to match the reflecting surface 301 of the test reticle 3 with the image height in the imaging illumination optical system 212 which is to be measured. In step S5, the processor P sets an illumination region. The processor P drives the masking blade in the illumination system 2 to illuminate only a portion near the reflecting surface 301 of the test reticle 3 corresponding to the image height to be measured. In step S6, the processor P drives the substrate stage 5 to be set in the state in Fig. 1A, that is, at a position where the light beam reflected by the reflecting surface 301 of the test reticle 3 and the surface of the optical element 201 passes through the light-receiving aperture 41 of the wafer side light amount sensor 4 via the projection optical system 1.

In step S7, the processor P oscillates a light source laser or the like to irradiate the test reticle 3 with the illumination light. In step S8, the exposure amount sensor 4' positioned in the illumination system 2 and the wafer side light amount sensor 4 positioned on the substrate stage 5 simultaneously measure the light amounts OUT(1a) and IN(1a). In step S9, the processor P stops oscillation of the light source laser or the like so as not to irradiate the test reticle 3 with illumination light.

In steps S10 and S11, the processor P drives the reticle stage 6 and the substrate stage 5 to set the state in Fig. 1B. In the state in Fig. 1B, a light beam passing through the transmissive aperture formed by the masking blade 214 directly passes through the light-receiving aperture 41 of the wafer side light amount sensor 4 without being reflected by the reflecting surface 301 or the like. In step S12, for example, the processor P oscillates the light source laser to irradiate the test reticle 3 with illumination light. In step S13, the exposure amount sensor 4' provided in the illumination system 2 and the wafer side light amount sensor 4 positioned on the substrate stage 5 simultaneously measure the light amounts OUT(1b) and IN(1b).

In step S14, for example, the processor P stops oscillation of the light source laser so as not to irradiate the test reticle 3 with illumination light.

In step S15, the processor P calculates the reflectance ILLR from the measurement values OUT(1b), IN(1b), OUT(1a), and IN(1a) and the incident angle characteristic values of the reflectance CDR of the reflecting surface 301 and of the transmittance GT of the glass surface of the test reticle 3 in consideration of the incident angle at the time of measurement. Note that as the incident angle characteristic values of the reflectance CDR of the reflecting surface 301 and of the transmittance GT of the glass surface of the test reticle 3, data stored in the exposure apparatus in advance can be used.

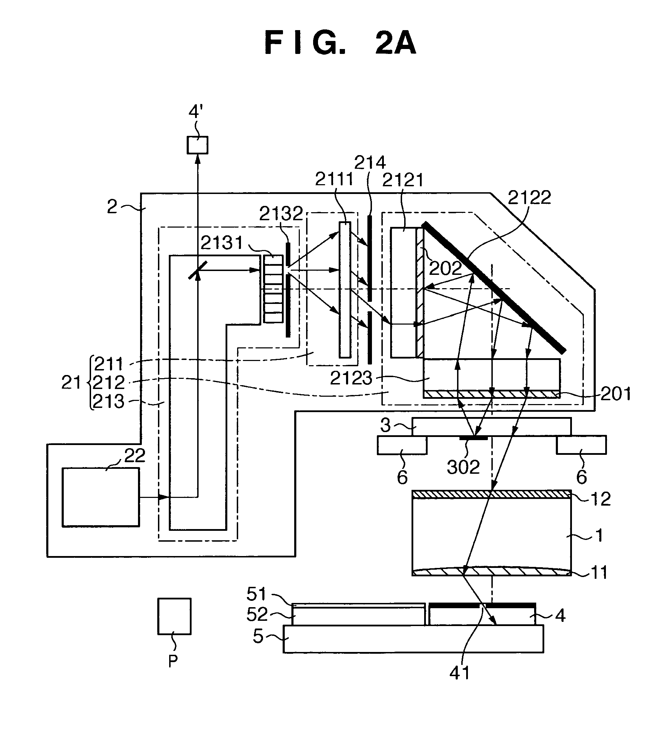

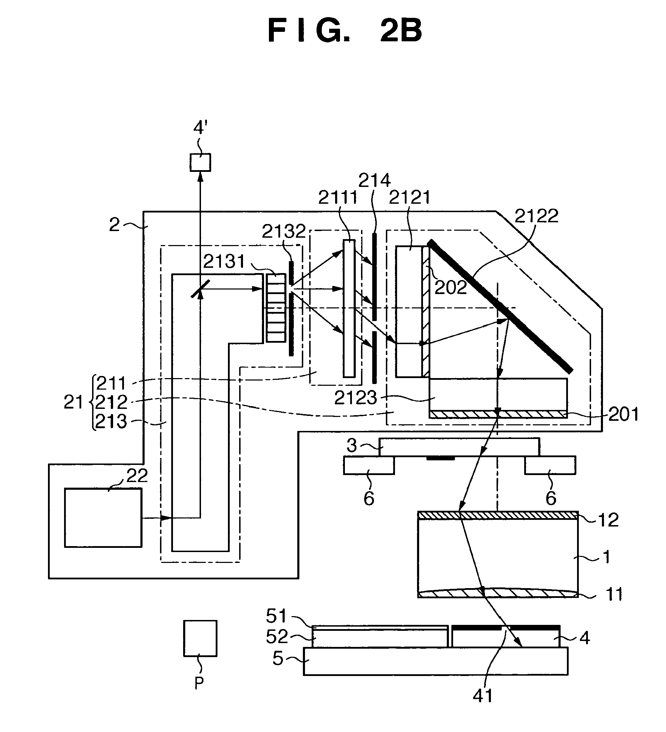

A second embodiment of the present invention will be described below referring to the drawings. Measurement of the reflectance of an optical element 202 in an illumination optical system 21 will be described with reference to Figs. 2A and 2B.

Measurement in the state in Fig. 2A will be described. The position of the transmissive aperture formed by a masking blade 214, the position of a reticle stage 6 (the position of a reflecting surface 302 of a test reticle 3), and the position of a substrate stage 5 in the state in Fig. 2A differ from those in the state in Fig. 1A. In this case, a processor P moves the substrate stage 5 on which a wafer side light amount sensor 4 is positioned to a position where the light reflected by the surface of a specific optical element 202 of a plurality of optical elements can be detected. The light detected by the wafer side light amount sensor 4 is limited to only light for the measurement of the reflectance of the optical element. Since light that causes a measurement error such as flare produced by the inner surface of a metal lens barrel forming the illumination optical system 21 is removed from the above light, a reliable reflectance can be measured.

Referring to Fig. 2A, the light beam reflected by the reflecting surface 302 of the test reticle is deflected by a bending mirror 2122 via a rear group 2123 of an imaging illumination optical system, and is reflected by the surface of the optical element 202 in a front group 2121 of the imaging illumination optical system. The light beam reflected by the surface of the optical element 202 is deflected by the bending mirror 2122, passes through the rear group 2123 of the imaging illumination optical system and the transmissive part of the test reticle 3, and enters a projection optical system 1.

The light beam entering the projection optical system 1 passes through a light-receiving aperture 41 of the wafer side light amount sensor 4 placed on the substrate stage 5, and is received by the wafer side light amount sensor 4 to be photoelectrically converted. At this time, the position of a light beam passing through the projection optical system 1 differs between the state in Fig. 2A and the state in Fig. 2B with respect to the transmittance PT of the projection optical system 1. However, since PT (the state in Fig. 2A) $\approx$ PT (the state in Fig. 2B), the following description will be made under the assumption that the transmittances PT of the projection optical system 1 in both the states are equal to each other.

Measurement in the state in Fig. 2A will be described quantitatively. In the state in Fig. 2A, assume that an exposure amount sensor 4' provided in an illumination system 2 and the wafer side light amount sensor 4 placed on the substrate stage 5 simultaneously perform light amount measurement. At this time, note that the light amount measured by the exposure amount sensor 4' provided in the illumination system 2 is represented by IN(2a) and the light amount measured by the wafer side light amount sensor 4 is represented by OUT(2a).

Letting T2123 be the transmittance of the rear group 2123 of the imaging illumination optical system, R2122 be the reflectance of the bending mirror 2122, and R202 be the reflectance of the optical element 202, the light amount in a state in which the light beam reflected by the surface of the optical element 202 has entered the test reticle 3 again and has passed through it is given by

$$K \cdot IT \cdot IN(2a) \cdot (GT^4) \cdot (T2123^2) \cdot (R2122^2) \cdot R202 \cdot CDR$$

The light amount OUT(2a) on the wafer side in the state in Fig. 2A is expressed as

$$OUT(2a) = K \cdot IT \cdot IN(2a) \cdot (GT^4) \cdot (T2123^2) \cdot (R2122^2) \cdot R202$$
$$\cdot CDR \cdot PT \cdot WT \cdot WK$$

Measurement in the state in Fig. 2B will be described next quantitatively. The state in Fig. 2B differs from the state in Fig. 1B only in the position of the transmissive aperture formed by the masking blade 214 and the position of the substrate stage 5. Therefore, the light amount OUT(2b) on the wafer side in the state in Fig. 2B is expressed as

$$OUT(2b) = K \cdot IT \cdot IN(2b) \cdot (GT^2) \cdot PT \cdot WT \cdot WK$$

The equations for OUT(2a) and OUT(2b) yield

$$R202 \cdot (T2123^2) \cdot (R2122^2) = \{OUT(2a)/IN(2a)/OUT(2b)/$$
$$IN(2b)\} \cdot \{1/(CDR \cdot GT^2)\}$$

In addition, regarding T2123 ≈ 1 and R2122 ≈ 1 yields

$$R202 \approx \{OUT(2a)/IN(2a)/OUT(2b)/IN(2b)\}$$
$$\cdot \{1/(CDR \cdot GT^2)\}$$

With approximations of T2123 ≈ 1 and R2122 ≈ 1, there is no issue when monitoring (repeating measurement every specific period of time) a change with time in the surface reflectance R202 of the optical element 202.

In this manner, the surface reflectance R202 of the optical element 202 can also be obtained by using the same equation as that used for the surface reflectance ILLR of the optical element 201 shown in the first embodiment.

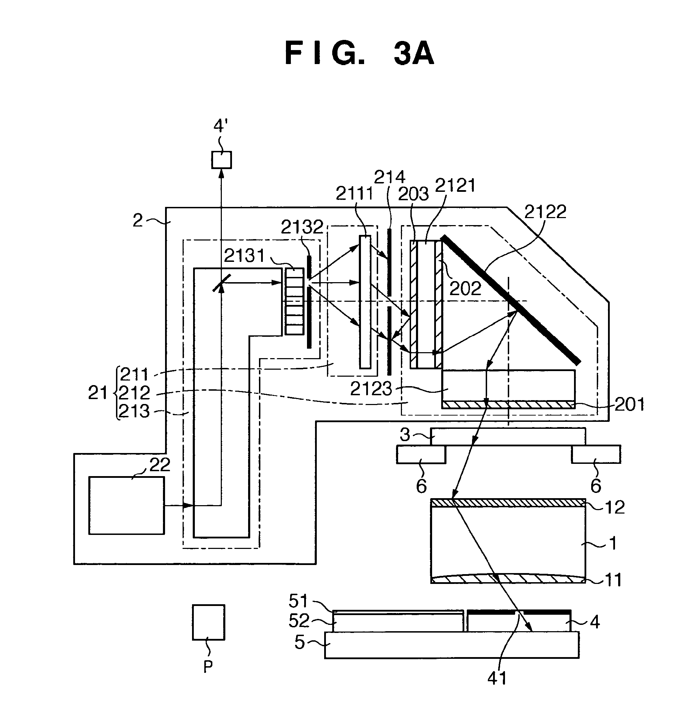

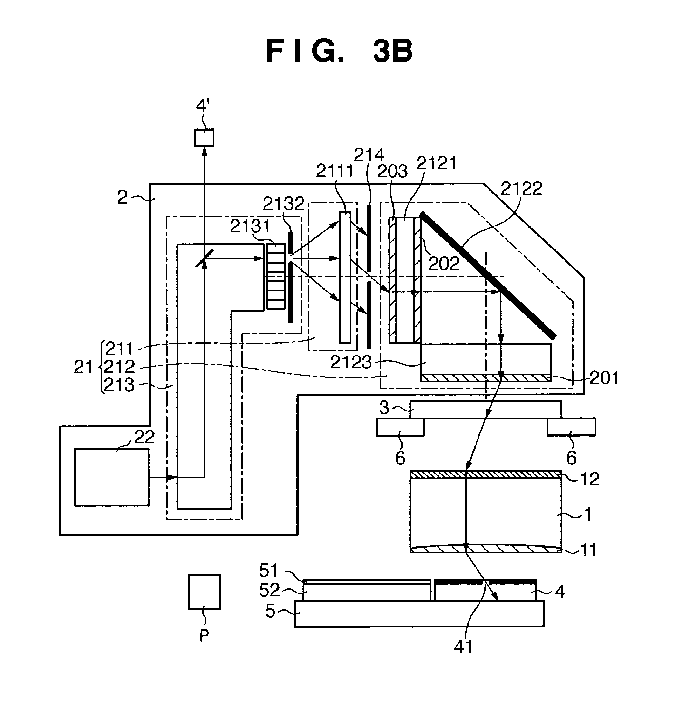

A third embodiment configured to measure the reflectance of an optical element 203 in an illumination optical system 21 will be described with reference to Figs. 3A and 3B. Note that a description similar to that made with reference to Figs. 1A and 1B will be omitted.

Measurement in the state in Fig. 3A will be described. A masking blade 214 is Koehler-illuminated with an obliquely incident light beam as in Fig. 1A. The masking blade 214 transmits only a light beam in part of the region Koehler-illuminated by a collimator 2111. The light beam passing through the masking blade 214 is reflected by the surface of the optical element 203 in a front group 2121 of the imaging illumination optical system. This light beam is further reflected by the surface of the masking blade 214, enters the front group 2121 of the imaging illumination optical system, and passes through the front group 2121 of the imaging illumination optical system. The surface of the masking blade 214 in this embodiment forms a reflecting surface positioned on or near a plane optically conjugate with the image plane of the illumination optical system 21.

The light beam passing through the front group 2121 of the imaging illumination optical system is deflected by a bending mirror 2122 and passes through a rear group 2123 of the imaging illumination optical system. This light beam further passes through a test reticle 3 and enters a projection optical system 1. The light beam entering the projection optical system 1 passes through a light-receiving aperture 41 of a wafer side light amount sensor 4 placed on a substrate stage 5 and is received by the wafer side light amount sensor 4 to be photoelectrically converted. The position of a light beam passing through the projection optical system 1 differs between the states in Figs. 3A and 3B. However, since PT (the state in Fig. 3A) ≈ PT (the state in Fig. 3B), the following description will be made under the assumption that the transmittances PT of the projection optical system 1 in both the states are equal to each other.

Measurement in the state in Fig. 3A will be described quantitatively. In the state in Fig. 3A, assume that an exposure amount sensor 4' provided in the illumination system 2 and the wafer side light amount sensor 4 placed on the substrate stage 5 simultaneously perform light amount measurement. At this time, note that the light amount measured by the exposure amount sensor 4' provided in an illumination system 2 is represented by IN(3a) and the light amount measured by the wafer side light amount sensor 4 is represented by OUT(3a).

The reflectance of the masking blade 214 is represented by R214. The light amount in a state in which the light beam reflected by the surface of the optical element 203 has been reflected by the masking blade 214 and has entered and passed through the test reticle 3 via the imaging illumination optical system 212 is given by

$$K \cdot IN(3a) \cdot R203 \cdot R214 \cdot IT \cdot (GT^2)$$

The light amount OUT(3a) on the wafer side in the state in Fig. 3A is expressed as

$$OUT(3a) = K \cdot IN(3a) \cdot R203 \cdot R214 \cdot IT \cdot (GT^2) \cdot PT \cdot WT \cdot WK$$

Measurement in the state in Fig. 3B will be described quantitatively. The state in Fig. 3B differs from the state in Fig. 1B only in the position of the transmissive aperture formed by the masking blade 214 and the position of the substrate stage 5. Therefore, the light amount OUT(3b) on the wafer side in the state in Fig. 3B is expressed as

$$\mathrm{OUT(3b)} = \mathrm{K \cdot IT \cdot IN(3b) \cdot (GT^2) \cdot PT \cdot WT \cdot WK}$$

Solving equations (4) and (5) for the light amounts OUT(3a) and OUT(3b) on the wafer side in the states in Figs. 3A and 3B for the surface reflectance R203 of the optical element 203 yields equation (6) as follows:

$$\mathrm{OUT(3a)} = \mathrm{K \cdot IT \cdot IN(3a) \cdot (GT^2) \cdot R203 \cdot R214 \cdot PT \cdot WT \cdot WK}$$

$$...(4)$$

$$\mathrm{OUT(3b)} = \mathrm{K \cdot IT \cdot IN(3b) \cdot (GT^2) \cdot PT \cdot WT \cdot WK} \qquad ...(5)$$

$$\mathrm{R203} = \{\mathrm{OUT(3a)/IN(3a)/OUT(1b)/IN(1b)}\} \cdot \{1/(\mathrm{R214})\}$$

$$...(6)$$

In this case, the relationship between the reflectance R214 of the glass surface of the masking blade 214 and the incident angle of measuring light is actually measured and stored in the exposure apparatus in advance.
The relationship between the second and third embodiments will be described next.
In the second embodiment, the reflectance of the surface of the optical element 202 in the front group 2121 of the imaging illumination optical system is obtained by

$$\mathrm{R202 \cdot (T2123^2) \cdot (R2122^2)} = \{\mathrm{OUT(2a)/IN(2a)/OUT(2b)/}$$

$$\mathrm{IN(2b)}\} \cdot \{1/(\mathrm{CDR \cdot GT^2})\}$$

The method in the third embodiment obtains the same reflectance of the surface of the optical element 202 according to

$$\mathrm{R202 \cdot (T2121)} = \{\mathrm{OUT(3a)/IN(3a)/OUT(1b)/}$$

$$\mathrm{IN(1b)}\} \cdot \{1/(\mathrm{R214})\}$$

where T2121 is the transmittance of the front group 2121 of the imaging illumination optical system.
Regarding that $\mathrm{T2123} \approx 1$, $\mathrm{R2122} \approx 1$, and $\mathrm{T2121} \approx 1$, the above two equations are expressed as follows.
(Technique in Second Embodiment)

$$\mathrm{R202} = \{\mathrm{OUT(2a)/IN(2a)/OUT(2b)/IN(2b)}\}$$

$$\cdot \{1/(\mathrm{CDR \cdot GT^2})\}$$

(Technique in Third Embodiment)

$$R202 \cdot (T2121) = \{OUT(3a)/IN(3a)/OUT(1b)/IN(1b)\}$$

$$\cdot \{1/(R214)\}$$

As described above, it is possible to obtain the reflectance of the optical element 202 in the imaging illumination optical system 212 by using either the technique in the second embodiment or the technique in the third embodiment.

It suffices to determine which one of the techniques is to be selected, from the following two points based on the design data of the lenses of the imaging illumination optical system 212 and projection optical system 1:

- the amount of light received by the wafer side light amount sensor 4; and
- the degree of separation from reflected measuring light from another surface.

Obviously, the technique that should be selected is a technique exhibiting a large amount of light received and a high degree of separation from reflected measuring light from another surface.

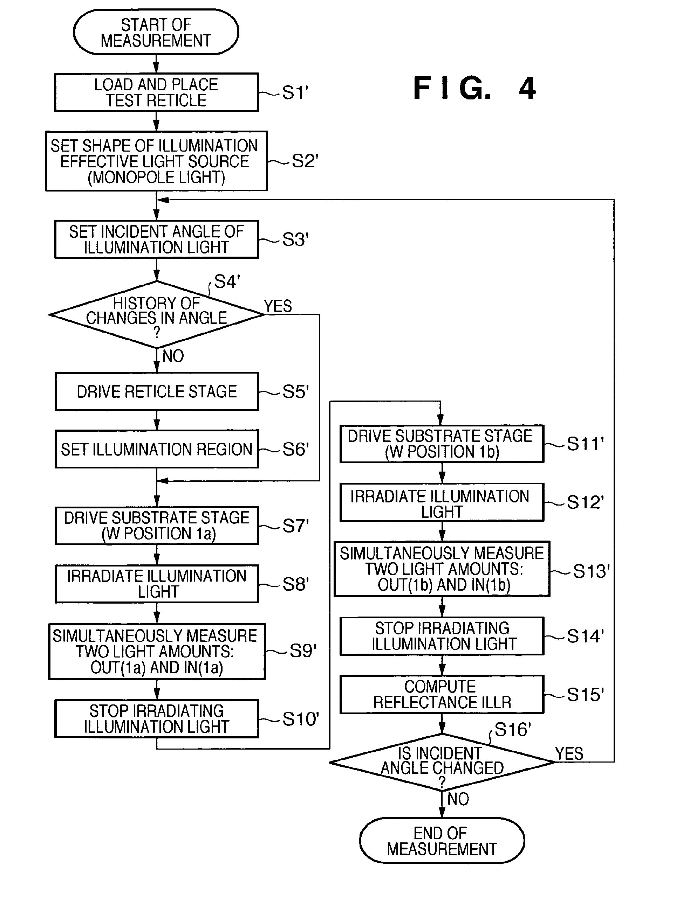

A fourth embodiment of the present invention will be described below referring to the drawings. Fig. 4 shows a flowchart for measurement in a case in which a plurality of incident angles of light on the imaging illumination optical system 212 and reflectances are obtained at the respective incident angles in the first embodiment. It is noted that the technique in the fourth embodiment can also be applied to the second and third embodiments.

First of all, letting $\theta 1$ be the initial set value of the incident angle of illumination light, a reflectance ILLR($\theta 1$) at the incident angle $\theta 1$ of illumination light is calculated. Since the details of the calculation of ILLR are the same as those in Fig. 1C, a repetitive description will be omitted.

A case in which the incident angle of illumination light is changed to $\theta 2$ will be described next. When the incident angle is to be set to $\theta 2$, it is not necessary to newly drive a reticle stage 6 or set an illumination region, but it suffices to set the same state as that set for the incident angle $\theta 1$. However, the driving position of a substrate stage 5 is set to the substrate stage position (1a, $\theta 2$) which is newly calculated for the incident angle $\theta 2$.

In the state of the substrate stage position 1a ($\theta 2$), light amounts OUT(1a, $\theta 2$) and IN(1a, $\theta 2$) are simultaneously measured. The substrate stage 5 is driven to the substrate stage position (1b, $\theta 2$) newly calculated for the incident angle $\theta 2$. In this state, light amounts OUT(1b, $\theta 2$) and IN($\theta b$, $\theta 2$) are simultaneously measured.

A reflectance ILLR($\theta 2$) at the incident angle $\theta 2$ of illumination light is calculated by using the measurement values OUT(1a, $\theta 2$), IN(1a, $\theta 2$), OUT(1b, $\theta 2$), and IN(1b, $\theta 2$).

Subsequently, measurement is performed up to an incident angle $\theta n$ of illumination light in the same manner as described above, and a reflectance ILLR($\theta n$) at the incident angle $\theta n$ of illumination light is calculated.

In this manner, it is possible to measure the surface reflectances ILLR($\theta 1$) to ILLR($\theta n$) of the optical element at the incident angles $\theta 1$ to $\theta n$ of illumination light. Based on changes in surface reflectances ILLR($\theta 1$) to ILLR($\theta n$) at the incident angles $\theta 1$ to $\theta n$, it is possible to estimate optical property values such as the refractive index and thickness of a contaminant adhering to the surface of the optical element.

It is noted that steps S1 to S3, S6 to S9, and S11 to S15 of Fig. 1C correspond to steps S1' to S3', S7' to S10', and S11' to S15' of Fig. 4, respectively. The flow chart in Fig. 4 also includes steps S4', S5', S6' and S16'. In step S4', the processor P determines whether or not there is a history of changes in an angle. If yes, the processor P goes to step S7'. Otherwise, the processor P goes to step S5'. In step S5', the processor P drives the reticle stage 6 to match the reflecting surface 301 of the test reticle 3 with the image height in the imaging illumination optical system 212. In step S6', the processor P sets the region illuminated by the illumination optical system 21. In step S16', the processor P determines whether or not there is any incident angle changes. If no, the processor P is terminated. Otherwise, the processor P goes back and set the incident angle of illumination light at step S3'.

In the first to fourth embodiments, the exposure amount sensor 4' in the illumination system 2 measures the light amounts In(1a) and In(1b) and the like. If, however, the light source can emit an almost constant amount of light, the light amounts In(1a) and In(1b) need not be measured. If the light source emits an almost constant amount of light, IN(1a) $\approx$ IN(1b).

In the first to fourth embodiments, for example, it suffices to perform measurement while adjusting the amount of light emitted from the light source to set OUT(1a) $\approx$ OUT(1b). This makes it possible to minimize the influences of a decrease in S/N ratio of both OUT(1a) and OUT(1b) due to electrical noise in the wafer side light amount sensor 4. In this case, the light amounts measured by the exposure amount sensor 4' in the illumination system 2 satisfy IN(1a) < IN (1b).

The first to fourth embodiments each have exemplified the case in which a reflectance is measured by the wafer side light amount sensor 4 formed on the substrate stage 5. However, the arrangement of the wafer side light amount sensor 4 is not limited to that fixed on the substrate stage 5. For example, it suffices to use an arrangement including a measurement unit such as a light amount sensor, a power supply, and a communication device on a circular plane-parallel plate having the same shape as that of the wafer 51. In this case, a light amount measurement result is transmitted to the main body of the exposure apparatus by wireless communication.

The third and fourth embodiments each have exemplified the case in which a reflectance is measured by the wafer side light amount sensor 4 formed on the substrate stage 5. However, it suffices to form a light amount sensor on the reticle stage 6 instead of the wafer side light amount sensor 4. It also suffices to use an arrangement including a measurement unit such as a light amount sensor 4, a power supply, and a communication device on a rectangular plane-parallel plate having the same shape as that of the test reticle 3. In this case, a light amount measurement result is transmitted to the main body of the exposure apparatus by wireless communication.

In each of the first and second embodiments, it suffices to use an arrangement including a measurement unit such as a light amount sensor, a power supply, and a communication device on a rectangular plane-parallel plate having the same shape as that of the test reticle 3 instead of the wafer side light amount sensor 4. In this case, a light amount receiving aperture and a reflecting surface are formed on the upper surface of a circular plane-parallel plate, and a light amount measurement result is transmitted to the main body of the exposure apparatus by wireless communication.

An example of a method of manufacturing a device such as a semiconductor integrated circuit element or a liquid crystal display element using the exposure apparatus described above will be described.

Devices are manufactured by a step of transferring by exposure a pattern onto a substrate using the exposure apparatus described above, a step of developing the substrate exposed in the exposing step, and other known steps (e.g., etching, resist removing, dicing, bonding, and packaging steps) of processing the substrate developed in the developing step.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

**Claims**

1. An exposure apparatus which projects a reticle pattern onto a substrate (51) and exposes the substrate, the apparatus **characterized by** comprising:

   an optical system (21) configured to illuminate a reticle, including an imaging optical system (212) having an optical element (201);
   a reflecting surface which reflects light toward the optical element; and
   a processor (P) which extracts information from a first signal based on first light which is incident on the imaging optical system and reflected by the reflecting surface and a surface of the optical element, and information from a second signal based on second light which is incident on the imaging optical system and is not reflected by the reflecting surface and the surface of the optical element, and which obtains information indicating a surface condition of the optical element using the information extracted from the first and second signals.

2. The apparatus according to claim 1, **characterized in that** the reflecting surface is positioned on or near an image plane of the optical system or a plane optically conjugate with the image plane.

3. The apparatus according to claim 1, **characterized in that** the reflecting surface is formed on a projection optical system side of a surface of a test reticle, positioned on or near an image plan of the optical system.

4. The apparatus according to claim 1, **characterized by** further comprising a first sensor which is positioned on a substrate stage and detects the first light and the second light,
   wherein the processor obtains the first signal and the second signal based on the first light and the second light, respectively detected by the first sensor.

5. The apparatus according to claim 1, **characterized by** further comprising a first sensor which is positioned on a reticle stage and detects the first light and the second light,
   wherein the reflecting surface is positioned on a plane optically conjugate with an image plane of the optical system or near a plane conjugate with the image plane, and
   the processor obtains the first signal and the second signal based on the first light and the second light, respectively detected by the first sensor.

6. The apparatus according to claim 4, **characterized by** further comprising a second sensor which is positioned between a light source and the imaging optical system and detects an amount of light incident on the imaging optical system,

wherein the processor obtains information indicating a surface condition of the optical element based on detection result obtained by the first and second sensors.

7. The apparatus according to claim 5, **characterized by** further comprising a second sensor which is positioned between a light source and the imaging optical system and detects an amount of light incident on the imaging optical system,

wherein the processor obtains information indicating a surface condition of the optical element based on detection result obtained by the first and second sensors.

8. The apparatus according to claim 4, **characterized in that**
the imaging optical system includes a plurality of optical elements, and
the processor moves the first sensor to a position where light reflected by a surface of an optical element of the plurality of optical elements is configured to be detected.

9. The apparatus according to claim 5, **characterized in that**
the imaging optical system includes a plurality of optical elements, and
the processor moves the first sensor to a position where light reflected by a surface of an optical element of the plurality of optical elements is configured to be detected.

10. The apparatus according to claim 1, **characterized in that** the surface condition of the optical element is a surface reflectance.

11. The apparatus according to claim 1, **characterized in that** the processor sets a plurality of incident angles of light with respect to the imaging optical system, and obtains information indicating the surface condition of the optical element concerning each of the plurality of incident angles.

12. A method of manufacturing a device, the method **characterized by** comprising:

exposing a substrate using an exposure apparatus according to any one of claims 1 to 11;
developing the exposed substrate; and
processing the developed substrate to manufacture the device.

EP 2 144 118 A1

# FIG. 1A

15

# FIG. 1B

FIG. 1C

START OF MEASUREMENT

LOAD AND PLACE TEST RETICLE — S1

SET SHAPE OF ILLUMINATION EFFECTIVE LIGHT SOURCE (MONOPOLE LIGHT) — S2

SET INCIDENT ANGLE OF ILLUMINATION LIGHT — S3

DRIVE RETICLE STAGE (R POSITION 1a) — S4

DRIVE MASKING BLADE (IRRADIATION POSITION 1a) — S5

DRIVE SUBSTRATE STAGE (W POSITION 1a) — S6

IRRADIATE ILLUMINATION LIGHT — S7

SIMULTANEOUSLY MEASURE TWO LIGHT AMOUNTS: OUT(1a) AND IN(1a) — S8

STOP IRRADIATING ILLUMINATION LIGHT — S9

DRIVE RETICLE STAGE (R POSITION 1b) — S10

DRIVE SUBSTRATE STAGE (DRIVING POSITION 1b) — S11

IRRADIATE ILLUMINATION LIGHT — S12

SIMULTANEOUSLY MEASURE TWO LIGHT AMOUNTS: OUT(1b) AND IN(1b) — S13

STOP IRRADIATING ILLUMINATION LIGHT — S14

COMPUTE REFLECTANCE ILLR — S15

END OF MEASUREMENT

17

# F I G. 2A

# F I G. 2B

# F I G. 3A

# F I G. 3B

**F I G. 4**

START OF
MEASUREMENT

LOAD AND PLACE
TEST RETICLE — S1'

SET SHAPE OF ILLUMINATION
EFFECTIVE LIGHT SOURCE
(MONOPOLE LIGHT) — S2'

SET INCIDENT ANGLE OF
ILLUMINATION LIGHT — S3'

HISTORY OF
CHANGES IN ANGLE
? — S4' — YES

NO

DRIVE RETICLE STAGE — S5'

SET ILLUMINATION REGION — S6'

DRIVE SUBSTRATE STAGE
(W POSITION 1a) — S7'

IRRADIATE ILLUMINATION
LIGHT — S8'

SIMULTANEOUSLY MEASURE
TWO LIGHT AMOUNTS:
OUT(1a) AND IN(1a) — S9'

STOP IRRADIATING
ILLUMINATION LIGHT — S10'

DRIVE SUBSTRATE STAGE
(W POSITION 1b) — S11'

IRRADIATE ILLUMINATION
LIGHT — S12'

SIMULTANEOUSLY MEASURE
TWO LIGHT AMOUNTS:
OUT(1b) AND IN(1b) — S13'

STOP IRRADIATING
ILLUMINATION LIGHT — S14'

COMPUTE
REFLECTANCE ILLR — S15'

IS INCIDENT
ANGLE CHANGED
? — S16' — YES

NO

END OF
MEASUREMENT

**Europäisches Patentamt**
**European Patent Office**
**Office européen des brevets**

# EUROPEAN SEARCH REPORT

Application Number

EP 09 00 8010

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 05 062883 A (NIPPON KOGAKU KK) 12 March 1993 (1993-03-12) | 1-4,6,8, 10,11 | INV. G03F7/20 |
| Y | * the whole document * | 5,7,9,12 | |
| X | US 5 905 569 A (SUZUKI AKIYOSHI [JP]) 18 May 1999 (1999-05-18) | 1-4,6,8, 10 | |
| Y | * the whole document * | 5,7,9 | |
| X | EP 1 308 991 A (NIPPON KOGAKU KK [JP]) 7 May 2003 (2003-05-07) | 1-4,6,8, 10 | |
| Y | * pages 5-7; figures 1-4 * | 5,7,9 | |
| Y | JP 2007 012949 A (MATSUSHITA ELECTRIC IND CO LTD) 18 January 2007 (2007-01-18) * paragraphs [0017] - [0027]; figures 1-4 * | 5,7,9,12 | |
| Y | WO 2005/057290 A (ASML NETHERLANDS BV [NL]; VAN HOUT FRITS JURGEN [BE]; VAN BOMMEL JOSEP) 23 June 2005 (2005-06-23) * paragraphs [0049] - [0062]; figures 1-3 * | 5,7,9,12 | |
| P,A | EP 2 020 619 A (CANON KK [JP]) 4 February 2009 (2009-02-04) * the whole document * | 1-12 | TECHNICAL FIELDS SEARCHED (IPC) G03F |

The present search report has been drawn up for all claims

| Place of search | Date of completion of the search | Examiner |
|---|---|---|
| Munich | 29 October 2009 | Roesch, Guillaume |

EPO FORM 1503 03.82 (P04C01)

**ANNEX TO THE EUROPEAN SEARCH REPORT
ON EUROPEAN PATENT APPLICATION NO.**

EP 09 00 8010

This annex lists the patent family members relating to the patent documents cited in the above-mentioned European search report.
The members are as contained in the European Patent Office EDP file on
The European Patent Office is in no way liable for these particulars which are merely given for the purpose of information.

29-10-2009

| Patent document cited in search report | | Publication date | Patent family member(s) | | Publication date |
|---|---|---|---|---|---|
| JP 5062883 | A | 12-03-1993 | NONE | | |
| US 5905569 | A | 18-05-1999 | JP | 3624048 B2 | 23-02-2005 |
| | | | JP | 9270374 A | 14-10-1997 |
| EP 1308991 | A | 07-05-2003 | AU | 2458202 A | 05-02-2002 |
| | | | WO | 0209163 A1 | 31-01-2002 |
| | | | US | 2004021854 A1 | 05-02-2004 |
| | | | US | 2006238749 A1 | 26-10-2006 |
| JP 2007012949 | A | 18-01-2007 | NONE | | |
| WO 2005057290 | A | 23-06-2005 | CN | 1890608 A | 03-01-2007 |
| | | | EP | 1695149 A2 | 30-08-2006 |
| | | | JP | 2007513526 T | 24-05-2007 |
| | | | KR | 20060107804 A | 16-10-2006 |
| | | | US | 2007273869 A1 | 29-11-2007 |
| EP 2020619 | A | 04-02-2009 | JP | 2009033048 A | 12-02-2009 |
| | | | KR | 20090013094 A | 04-02-2009 |
| | | | US | 2009033904 A1 | 05-02-2009 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11283903 A